# EUROPEAN PATENT SPECIFICATION

(11) **EP 3 780 110 B1**
(45) Date of publication and mention of the grant of the patent: **01.05.2024**
(21) Application number: 18917888.2
(22) Date of filing: 26.07.2018
(51) Int. Cl.: H04M 1/02, G06F 1/16, H10K 59/80

(54) **MOBILE TERMINAL HAVING FLEXIBLE DISPLAY PANEL**
MOBILES ENDGERÄT MIT FLEXIBLEM DISPLAY
TERMINAL MOBILE AVEC PANNEAU D'AFFICHAGE SOUPLE

(30) Priority: 08.05.2018 CN 201810433401
(43) Date of publication of application: 17.02.2021
(73) Proprietor: HUAWEI TECHNOLOGIES CO., LTD., Shenzhen, Guangdong 518129 (CN)
(72) Inventor: MAO, Weihua, Shenzhen, Guangdong 518129 (CN); WU, Bo, Shenzhen, Guangdong 518129 (CN); SHENG, Jianqing, Shenzhen, Guangdong 518129 (CN); XU, Haowen, Shenzhen, Guangdong 518129 (CN); HE, Haiming, Shenzhen, Guangdong 518129 (CN)
(74) Representative: Maiwald GmbH
(86) International application number: PCT/CN2018/097290
(87) International publication number: WO 2019/214083

(56) References cited:
- CN-A- 103 676 371
- CN-A- 105 334 911
- CN-A- 106 444 129
- CN-A- 106 783 872
- CN-A- 106 783 881
- US-A1- 2013 044 282
- US-A1- 2015 378 197
- US-A1- 2018 092 166

## Description

This application claims priority to Chinese Patent Application No. 201810433401.4, filed with the Chinese Patent Office on May 8, 2018 and entitled "TERMINAL".

### TECHNICAL FIELD

This application relates to the field of communications technologies, and in particular, to a mobile terminal having a flexible display panel.

### BACKGROUND

With development of a flexible OLED technology, curved displays gradually become a mainstream of mobile phone terminals. However, based on technical maturity and a manufacturing process of flexible OLEDs, there are some constraints and costs in application of curved mobile phone products.
CN106444129A describes a liquid crystal panel which comprises a liquid crystal panel body. The liquid crystal panel body comprises an upper glass substrate and a lower glass substrate. An upper flexible substrate layer is arranged on the surface of the inner side of the upper glass substrate, a lower flexible substrate layer is arranged on the surface of the inner side of the lower glass substrate, a first polarization layer and a second polarization layer are arranged on the surfaces of the outer sides of the upper glass substrate and the lower glass substrate or the upper flexible substrate layer and the lower flexible substrate layer respectively, the parts, close to the edges, of the two opposite sides of the surfaces of the outer sides of the upper glass substrate and the lower glass substrate are each provided with at least one cutting groove, the edges, adjacent to the cutting grooves, on the upper glass substrate and the lower glass substrate are bent towards the same side along the cutting grooves, the two opposite sides of the liquid crystal panel body are each provided with at least one side display face, and the cutting grooves are filled with filling adhesives. US2015/378197A1 describes that an electronic device includes: a main body of the electronic device; a display, provided on the main body of the electronic device, where the display includes a first light transmitting layer, and a support layer between the main body of the electronic device and the first light transmitting layer, and where the first transmitting layer is located on a first surface of the electronic device; N sensors, provided in the display, and located inside the first transmitting layer, wherein a capturing module of the N sensors faces an inner surface of the first transmitting layer; and the N sensors are adapted to capture ambient light penetrating the first light transmitting layer or ambient light irradiating the N sensors via a through hole of the first light transmitting layer.
US2018/092166A1 describes a flexible display having a plurality of innovations configured to allow bending of a portion or portions to reduce apparent border size and/or utilize the side surface of an assembled flexible display.

However, a light transmittance in the prior art is low. A light transmittance of a PI base material in the flexible OLED is low, and is only 70% or lower. For imaging quality of a camera, the light transmittance is a key requirement, and it can be accepted only when the transmittance reaches about 85%. A current color of the PI base material of the flexible OLED is relatively yellow, and cannot meet the requirement of the imaging quality of the camera. In addition, when a curved display is fastened, an arched bending part of the curved display cannot be well supported.

### SUMMARY

This application provides a mobile terminal having a flexible display panel to improve a use effect of the mobile terminal.
In a first aspect, there is provided a mobile terminal as defined in appended claim 1.The invention and its scope of protection is defined by independent claim 1. The following examples provide a non-limiting understanding of how component features of the disclosure can be combined.

According to a first example, a flexible display panel is provided, where the flexible display panel is applied to a mobile terminal. The flexible display panel mainly includes a flexible glass substrate and a display module disposed on the flexible glass substrate. The flexible glass substrate is used as a support structure, and a first bending structure is disposed on each of two opposite edges of the flexible glass substrate. The flexible display panel forms an arc-shaped display panel when the display module is supported. In addition, the flexible display panel further includes an encapsulation layer, where the encapsulation layer encapsulates the display module on the flexible glass substrate. For the flexible display panel, the flexible glass substrate is used to carry the display module, thereby improving transparency of the entire flexible display panel. When a buried device is used in the mobile terminal, the flexible glass substrate is used to improve light transmission performance of the entire flexible display panel. In addition, no hole needs to be drilled on the flexible glass substrate, thereby improving a support effect of the entire flexible glass substrate.

To further enhance a light transmission effect, a through hole used for light transmission is correspondingly disposed on the display module. When the flexible display panel is disposed in the mobile terminal, the through hole is correspondingly disposed with the buried device, to further improve light transmission of the entire flexible display panel.

A structure of the display module may be different. For example, the display module includes a stacked anode, an emission layer, and a cathode. During specific disposition, the anode and the cathode are disposed opposite to each other, the emission layer is located in the middle, and the anode is disposed on the glass substrate. The encapsulation layer covers the cathode, and encapsulates the entire display module on the flexible glass substrate. Certainly, a structure of the display module is not limited to the foregoing several types, and may further include a hole injection layer, a hole transport layer, an electronic injection layer, and an electronic transport layer. When the foregoing several structures are used, holes are also correspondingly punched on the structures, to improve light transmission performance of the entire flexible display panel.

The encapsulation layer may be prepared by using different materials, for example, an organic film layer or an inorganic film layer, and both the organic film layer and the inorganic film layer have a good encapsulation effect.

When the flexible glass substrate is specifically disposed, to ensure a flexible effect of the flexible glass substrate, a thickness of the flexible glass substrate is from 0.02 mm to 0.3 mm, for example, different thicknesses such as 0.02 mm, 0.05 mm, 0.1 mm, 0.15 mm, 0.2 mm, 0.25 mm, and 0.3 mm. When the foregoing thickness is used, it can be ensured that the flexible glass substrate has specific support strength, and also has specific flexibility.

According to a second example, a mobile terminal is provided. The mobile terminal includes a support component and a flexible display panel disposed on the support component in a stacked manner. The support component is adhesively connected to the flexible display panel when being disposed in the stacked manner. The flexible display panel is the foregoing flexible display panel, and a flexible glass substrate of the flexible display panel has specific flexibility, so that bending can be implemented. Therefore, a first bending structure can be disposed on each of two opposite edges of the flexible display panel. When the support component is specifically disposed, an arc-shaped support surface is disposed on each of two sides of the support component, and the first bending structures of the flexible display panel are covered on the support surfaces in a one-to-one correspondence. Flexibility of the flexible glass substrate enables the flexible display panel to be bent. In addition, the first bending structure of the flexible display panel may be fastened by using the arc-shaped support surface on the support component based on an adhesive relationship between the flexible display panel and the support component. In this way, a curved display is disposed. In addition, because the used flexible glass substrate has good light transmission, a use effect of a hidden device can be improved, and a use effect of the mobile terminal can be further improved.

There are different support components in the mobile terminal, and the following uses a specific example for description. In a specific implementation solution, the support component is a transparent cover, and an arc-shaped second bending structure is disposed on each of two sides of the transparent cover, and an inner concave surface of each second bending structure is the foregoing support surface. During specific disposition, the inner concave surfaces of the second bending structures are oppositely disposed, and parts that are located in the two second bending structures are flat-plate structures, so that the entire transparent cover forms a "C" structure. The flexible display panel is disposed in an inner concave surface of the C-shaped structure, and forms a C-shaped bending structure by limiting from the transparent cover.

A thickness of the transparent cover may be disposed in different manners. In a specific implementation solution, the transparent cover is a transparent cover with an equal thickness. In other words, thicknesses of the flat-plate structure and the second bending structures on the two sides are the same. In another implementation solution, the transparent cover is disposed in an unequal thickness manner. During specific disposing, the second bending structure of the transparent cover is a structure whose thickness gradually changes, and a thickness of the bending structure gradually increases in a direction in which a center of the flexible cover points to the bending structure. When the structure is used, a thickness of the flat-plate structure of the transparent cover is equal, and only the thickness of the second bending structure gradually changes. The second bending structure of the transparent cover is the structure whose thickness gradually changes, and the thickness of the bending structure gradually decreases in directions extending from a center line of the second bending structure to two sides. In this way, protection for the first bending structure at the edge of the flexible display panel is enhanced.

A material of the transparent cover should have relatively good light transmission performance. Specifically, the transparent cover is a glass cover or an acrylic cover.

When the flexible display panel is specifically adhered to the transparent cover, the transparent cover is adhesively connected to the flexible display panel by using optical adhesive.

A shape of the transparent cover is not limited to the foregoing structure, and another structure form may be used. For example, a surface that is on the transparent cover and that faces away from the flexible display panel is a wave surface, so that different effects can be displayed. In addition, a surface that is of the transparent cover and that faces the transparent cover is a wave surface or a plane. When both a surface facing the transparent cover and a surface facing away from the flexible display panel are wave surfaces, wave crests and wave troughs of one of the wave surfaces respectively correspond to those of the other wave surface.

In addition, the support may be a middle frame, and an outer side surface of a side wall of the middle frame is the support surface. The outer side surface is an arc-shaped surface.

When the middle frame is connected to the support component, the middle frame is adhesively connected to the flexible display panel by using adhesive.

When the middle frame is used as the support component, the mobile terminal further includes a transparent cover covering the flexible display panel. For a structure of the transparent cover, refer to the foregoing structure of the transparent cover used as the support component.

### BRIEF DESCRIPTION OF DRAWINGS

FIG. 1 is a schematic structural diagram of a flexible display panel according to an embodiment of this application;
FIG. 2 is a schematic exploded view of a flexible display panel according to an embodiment of this application;
FIG. 3 is a schematic diagram of a local structure of a mobile terminal according to an embodiment of this application;
FIG. 4 is a schematic structural diagram of a transparent cover according to an embodiment of this application;
FIG. 5 is a schematic structural diagram of a transparent cover according to an embodiment of this application;
FIG. 6 is a schematic structural diagram of a transparent cover according to an embodiment of this application;
FIG. 7 is a schematic structural diagram of a transparent cover according to an embodiment of this application;
FIG. 8 is a schematic structural diagram of another transparent cover according to an embodiment of this application; and
FIG. 9 is a schematic diagram of another local structure of a mobile terminal according to an embodiment of this application.

### DESCRIPTION OF EMBODIMENTS

To make the objectives, technical solutions, and advantages of this application clearer, the following further describes this application in detail with reference to the accompanying drawings.

For ease of description, in the embodiments of this application, a mobile terminal is first described. The mobile terminal is a common mobile terminal such as a mobile phone, a tablet computer, or a notebook computer, or certainly may be an existing known mobile terminal.

To improve a use effect of the mobile terminal, in the embodiments of this application, a flexible display panel of the mobile terminal and a support component supporting the flexible display panel are mainly improved. However, it should be understood that the mobile terminal provided in this embodiment of this application is a complete mobile terminal, and also has a known structure of the mobile terminal. Only components related to improving a display effect of the mobile terminal in the mobile terminal are described herein, other components are not described in detail.

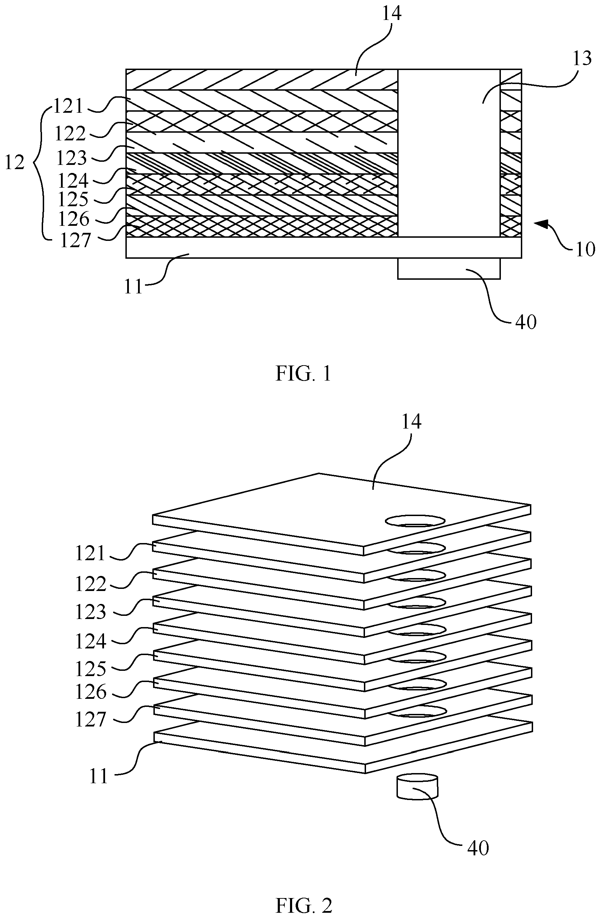

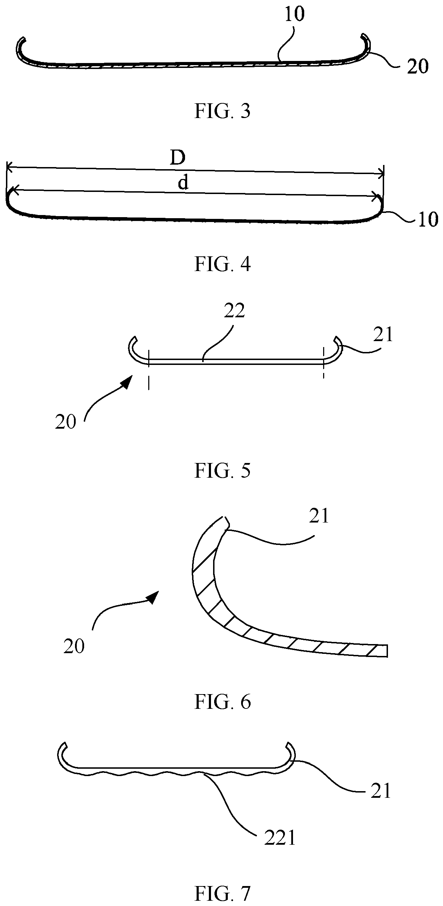

First, referring to FIG. 1 and FIG. 2, FIG. 1 shows a sectional view of a flexible display panel 10, and FIG. 2 shows a schematic exploded view of the flexible display panel 10. First, referring to FIG. 1, the flexible display panel 10 provided in an embodiment of this application includes three parts: a flexible glass substrate 11, a display module 12 disposed on the flexible glass substrate 11, and an encapsulation layer 14 encapsulating the display module 12 on the flexible glass substrate 11. The flexible glass substrate 11 is used as a bearing component to support the display module 12, the flexible glass substrate 11 has specific flexibility, and the flexible display panel 10 can be bent to some extent based on flexibility of a glass base material. In the structure shown in FIG. 1, an effect obtained after the flexible display panel 10 is bent is not shown. FIG. 3 is a schematic diagram of a local structure of a mobile terminal. FIG. 3 shows a bending effect of the flexible display panel 10. In FIG. 3, a bending structure may be disposed on each of two ends of the flexible display panel 10, and correspondingly a first bending structure is also disposed on each of two opposite edges of the flexible glass substrate 11, so that the flexible display panel 10 can be attached to a protection cover of the mobile terminal to form a curved display. To enable the flexible display panel 10 to implement the foregoing bending, a thickness of the flexible glass substrate 11 needs to ensure that the flexible glass substrate 11 has specific support strength, and also has specific flexibility. During specific disposition, the thickness of the flexible glass substrate 11 is from 0.02 mm to 0.3 mm. Specifically, any thickness from 0.02 mm to 0.3 mm may be used, such as 0.02 mm, 0.05 mm, 0.1 mm, 0.15 mm, 0.2 mm, 0.25 mm, and 0.3 mm. When the foregoing thickness is used, it can be ensured that the flexible glass substrate 11 has the specific support strength, and also has the specific flexibility.

For the flexible glass substrate 11, one flexible glass substrate 11 may be used, or more flexible glass substrates 11 may be stacked, so that protection for the display module 12 can be improved while the flexibility of the flexible glass substrate 11 is ensured. In addition, when the flexible glass substrate 11 is used, light transmission performance of the flexible display panel 10 is greatly improved. When a hidden device 40 is used in the mobile terminal, a light irradiation effect on the hidden device 40, for example, a recessed camera, is improved, thereby improving a use effect of the entire mobile terminal.

Certainly, in this embodiment of this application, the flexible glass substrate 11 includes another flexible material other than a PI material, and the another flexible material may be more specifically a glass matrix composite material. The glass matrix composite material is a composite material formed in a composite process by using a glass material as a matrix and using fibers such as ceramic, carbon, and metal, whiskers, and wafers as reinforcements, to improve toughness and strength of an original matrix material after being compounded. The matrix of the glass matrix composite material mainly includes borosilicate glass (600°C), aluminosilicate glass (700°C), and high-silica glass (1150°C), and is applicable to different temperatures. Glass ceramic (microcrystalline glass) is sometimes classified into the composite material. Toughness of the glass matrix composite material is definitely improved compared with that of an original glass matrix. For example, strength of a short fiber reinforced glass is 50 MPa to 150 MPa, a breaking work is 600 J·m⁻² to 800 J·m⁻², and breaking toughness is 7 MPa·m^{1/2}. Strength of a common glass is 100 MPa, a breaking work is 2 J·m^{1/2} to 4 J m^{1/2}, and breaking toughness is 0.5 J m^{1/2}. It can be learned from the foregoing description that when the glass matrix composite material is used, the flexibility of the flexible glass substrate 11 can be further improved.

Still referring to FIG. 1 and FIG. 2, in the structure shown in FIG. 1, the display module 12 is a multilayer stacked structure. Using a placement direction of the flexible display panel 10 shown in FIG. 1 as a reference direction, the flexible display panel 10 sequentially includes: an anode 127, a hole injection layer 126, a hole transport layer 125, an emission layer 124, an electronic transport layer 123, an electronic injection layer 122, and a cathode 121 from bottom to top. The anode 127 is disposed on the flexible glass substrate, and the encapsulation layer 14 encapsulates the cathode 121. Still referring to FIG. 1, a through hole 13 is disposed on the display module 12, and the through hole 13 passes through all layers of the display module 12. During specific formation, a hole is disposed at each layer. When all the layers are stacked, the holes at the layers are connected to form the through hole 13 in FIG. 1. FIG. 2 shows a structure of each layer in the schematic exploded view. A hole is disposed on each of the anode 127, the hole injection layer 126, the hole transport layer 125, the emission layer 124, the electronic transport layer 123, the electronic injection layer 122, and the cathode 121. After all the layers are stacked, as shown in FIG. 1, the holes at all the layers are stacked to form the co-axial through hole 13. The through hole 13 is a light transmission hole. As shown in FIG. 1, when the hidden device 40 is attached to the bottom of the flexible display panel 10, the light transmission hole corresponds to the hidden device 40, so that light can be irradiated on the hidden device 40 after passing through the through hole 13 and the flexible glass substrate 11, or light irradiated from the hidden device 40 passes through the flexible glass substrate 11 and the through hole 13 and then is irradiated. It can be seen from FIG. 1 and FIG. 2 that, when the flexible glass substrate 11 is used, because the flexible glass substrate 11 is prepared by using the glass base material, a good light transmission effect is achieved. Therefore, a good light transmission effect can be achieved without drilling a hole. In addition, because no hole needs to be disposed, a complete structure can be maintained for the flexible glass substrate 11. When the flexible glass substrate 11 is bent, a force-bearing effect of the flexible glass substrate 11 is improved, to avoid cracks in the edge of the hole caused by opening, thereby improving reliability of the flexible glass substrate 11. In addition, compared with a flexible display panel supported by using a PI base material in the prior art, the flexible glass substrate has a better light transmission effect, and there is no need to drill a hole on the flexible glass substrate, thereby reducing a processing step of the entire flexible display panel.

It should be understood that the structure of the display module 12 shown in FIG. 1 and FIG. 2 is merely a specific structure of the display module 12. The display module 12 provided in this embodiment of this application may further include a display module 12 of another structure. For example, the display module 12 includes only a three-layer structure including the anode 127, the emission layer 124, and the cathode 121, and can also implement display. Therefore, the display module 12 may also be applied to this embodiment of this application. For another example, the display module 12 may further include a structure such as a polarizer or a touch panel, and may also be applied to this embodiment of this application.

Different materials may be used for the encapsulation layer provided in this embodiment of this application. An inorganic film layer or an organic film layer may be used, and both the inorganic film layer and the organic film layer have a good encapsulation effect and good light transmission performance.

FIG. 3 shows a structure of a mobile terminal according to an embodiment of this application. In this embodiment of this application, the mobile terminal includes two components: a support component and a flexible display panel 10. When the support component and the flexible display panel 10 are specifically disposed, the support component and the flexible display panel 10 are disposed in a stacked manner, and the support component and the flexible display panel 10 are fastened in an adhesive connection manner. In a specific adhering manner, the flexible display panel 10 may be adhesively connected to the support component by using optical adhesive. Certainly, other glue may also be used for adhesive connection, and specifically, selection may be performed in a manner in which different components are used as support components.

The flexible display panel 10 provided in this embodiment of this application is an arc-shaped display panel. For a specific structure of the flexible display panel 10, refer to the foregoing description of the flexible display panel 10. In addition, a first bending structure is disposed on each of two sides of the flexible display panel 10. When the first bending structure is specifically disposed, the first bending structure is an arc-shaped bending structure. Referring to FIG. 4, a distance d between ends of two first bending structures is less than a maximum width D of the entire flexible display panel 10, so that the first bending structure can enclose a relatively large part of side walls of the mobile terminal. Therefore, a display region on the first bending structure has a relatively large display area, and the first bending structure has a sufficient display area for displaying.

The support component provided in this embodiment of this application is used as a support structure and a fastening structure that support the flexible display panel 10. The support component may be different devices, for example, a transparent cover 20 or a middle frame 30. The following separately uses the transparent cover and the middle frame as examples to describe a structure of the support component.

Still referring to FIG. 3 and FIG. 5, the support component in the structure shown in FIG. 3 uses the transparent cover 20, and FIG. 5 shows a structure of the transparent cover 20. A material of the transparent cover 20 should have relatively good light transmission performance. For example, the transparent cover 20 is a glass cover, an acrylic cover, or another composite material with good light transmission. For the structure of the transparent cover 20, the transparent cover 20 may use different structures. FIG. 5 shows a specific structure of the transparent cover 20. In the structure shown in FIG. 5, an arc-shaped second bending structure 21 is disposed on each of two sides of the transparent cover 20, and a flat-plate structure 22 is located between the two second bending structures 21. In addition, the flat-plate structure and the two second bending structures 21 are an integrated structure. When the two second bending structures 21 are specifically disposed, inner concave surfaces of the two second bending structures 21 are disposed opposite to each other, so that the entire transparent cover 20 forms a "C" structure. The inner concave surface of each second bending structure 21 is an arc-shaped support surface, the support surface is configured to support a first bending structure of the flexible display panel 10, and a surface that is of the flat-plate structure 22 and that is connected to the support surface is also a surface supporting the flexible display panel 10. When the flexible display panel 10 and the transparent cover 20 are stacked, a C-shaped bending structure is formed by limiting from the transparent cover 20. In addition, when the flexible display panel 10 is specifically adhered to the transparent cover 20, the transparent cover 20 is adhesively connected to the flexible display panel 10 by using optical adhesive, thereby reducing impact on light transmission of the flexible display panel 10. In addition, when the optical adhesive is disposed, thicknesses of the optical adhesive may be different. For example, a thickness of the optical adhesive coated to the first bending structure and the second bending structure 21 is relatively large, so that the flexible display panel 10 can be protected by using the optical adhesive as a buffer layer.

When the transparent cover 20 uses the structure shown in FIG. 5, a thickness of the transparent cover 20 may be disposed in different manners. For example, in a specific implementation solution, the transparent cover 20 is a transparent cover 20 with an equal thickness, in other words, the flat-plate structure 22 and the second bending structures 21 on the two sides have a same thickness. As shown in FIG. 6, in another implementation solution, the transparent cover 20 is disposed in an unequal thickness manner. In this case, a thickness of the second bending structure 21 is greater than a thickness of the flat-plate structure 22. In addition, in the structure shown in FIG. 6, the thickness of the flat-plate structure of the transparent cover 20 is equal (not shown in FIG. 6), but the thickness of the second bending structure 21 gradually changes. In a thickness change process, the thickness of the second bending structure 21 gradually decreases in directions extending from a center line of the second bending structure 21 to two sides. It can be learned from the foregoing description that the second bending structure 21 is configured to protect the first bending structure of the flexible display panel 10. In addition, for the mobile terminal, the first bending structure is located on a side wall of the mobile terminal. Therefore, the thickened second bending structure 21 can improve protection for the first bending structure, to improve security of the mobile terminal in use.

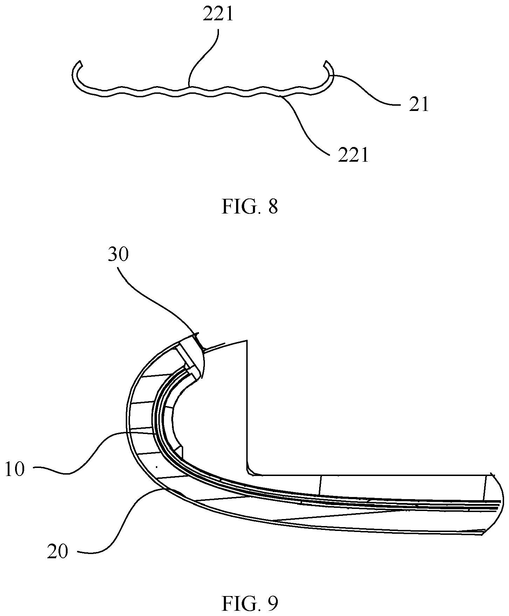

In addition to that the second bending structure 21 may use different manner, for the structure of the transparent cover 20, the transparent cover 20 may use another different manner. As shown in FIG. 7, a surface that is of the transparent cover 20 and that faces away from the flexible display panel 10 is a wave surface 221, so that different effects can be displayed. In addition, a surface that is of the transparent cover 20 and that faces the transparent cover 20 is a wave surface 221 or a plane. As shown in FIG. 8, when both the surface facing the transparent cover 20 and the surface facing away from the flexible display panel 10 are the wave surfaces 221, wave crests and wave troughs of one of the two wave surfaces 221 respectively correspond to those of the other wave surface 221. Two opposite surfaces of the flat-plate structure 22 on the transparent cover 20 separately face the flexible display panel 10 and face away from the flexible display panel 10. The flat-plate structure 22 corresponds to a front display region of the mobile terminal. The flat-plate structure 22 is disposed by using the wave surface 221, an effect of the flexible display panel 10 during display can be changed.

FIG. 9 shows a structure in which a middle frame 30 is used as a support component. When the middle frame 30 is specifically disposed, the middle frame 30 has two opposite side walls, and an outer side surface of the side walls is a support surface. As shown in FIG. 9, the outer side surface is an arc-shaped surface. When the middle frame 30 and the flexible display panel 10 are stacked, the support surface supports the first bending structure, so that the entire first bending structure can form a stable bending. In addition, when the middle frame 30 is connected to the support component, the middle frame 30 is adhesively connected to the flexible display panel 10 by using adhesive, so that the flexible display panel 10 can be stably connected to the middle frame 30, and stability of the flexible display panel 10 is ensured. In addition, when the middle frame 30 is used as a support component, to protect the flexible display panel 10, the mobile terminal further includes a transparent cover 20 covering the flexible display panel 10. For a structure of the transparent cover 20, refer to the foregoing structure of the transparent cover 20 used as the support component. Details are not described herein.

It can be learned from the foregoing descriptions of the support component and the flexible display panel 10 that, the support component provided in this embodiment of this application may support the flexible display panel 10 by using different structures. In addition to the middle frame 30 and the transparent cover 20, another component may be further used, for example, a support bracket is used to support the flexible display panel 10, and then is connected to the middle frame 30 of the mobile terminal.

In the mobile terminal provided in this embodiment of this application, the flexible display panel 10 can form a stable structure by using cooperation between the support component and the flexible display panel 10. Therefore, support for the flexible display panel 10 is improved, and light transmission of the flexible display panel 10 is improved when the flexible glass substrate is used. This facilitates a photographing effect of the hidden camera in the mobile terminal, and improves the use effect of the mobile terminal.

## Claims

1. A mobile terminal, comprising a glass or acrylic transparent cover (20) and a flexible display panel (10), the flexible display panel (10), comprising a flexible glass substrate (11) and a display module (12) disposed on the flexible glass substrate (11), and further comprising an encapsulation layer (14) encapsulating the display module on the flexible glass substrate;
wherein a first arc shaped bending structure is disposed on each of two opposite edges of the flexible glass substrate;
wherein a second arc-shaped bending structure (21) is disposed on each of two opposite sides of the glass or acrylic transparent cover;
wherein a flat-plate structure (22) of the glass or acrylic transparent cover has a constant thickness, and wherein the second bending structure of the glass or acrylic transparent cover is a structure whose thickness gradually changes, wherein the thickness of the second bending structure gradually increases in a direction towards the outer extent of the second bending structure from the thickness of the flat-plate structure where the second bending structure is joined to the flat-plate structure to a maximum thickness at a center line of the second bending structure and the thickness of the second bending structure then gradually decreases in thickness in the direction towards the outer extent of the second bending structure from the thickness at the center line to a thickness at the outer extent;
wherein a flexibility of the flexible glass substrate enables the flexible display panel to be bent such that glass or acrylic transparent cover (20) can be connected to the flexible display panel;
wherein when the glass or acrylic transparent cover (20) is connected to the flexible display panel inner concave surfaces of the second arc-shaped bending structures (21) connect to the first arc-shaped bending structures and cover the first arc-shaped bending structures in a one-to-one correspondence;
wherein when the glass or acrylic transparent cover (20) is connected to the flexible display panel the glass or acrylic transparent cover (20) is adhesively connected to the flexible display panel.

2. The mobile terminal 1 according to claim 1, wherein a through hole (13) used for light transmission is disposed on the display module.

3. The mobile terminal according to claim 2, wherein the display module comprises an anode (127) disposed on the flexible glass substrate, an emission layer disposed on the anode, and a cathode (121) disposed on the emission layer (124), the encapsulation layer covers the cathode, wherein the display module further comprises a hole injection layer, a hole transport layer, an electronic injection layer, and an electronic transport layer and the through hole passes through all layers of the display module.

4. The mobile terminal according to any one of claims 1 to 3, wherein the encapsulation layer is an organic film layer or an inorganic film layer.

5. The mobile terminal according to any one of claims 1 to 4, wherein a thickness of the flexible glass substrate is from 0.02 mm to 0.3 mm (including 0.02 mm and 0.3 mm).

6. The mobile terminal according to claim 1, wherein the glass or acrylic transparent cover is adhesively connected to the flexible display panel by using optical adhesive.

7. The mobile terminal according to any one of claims 1 or 6, wherein a surface that is on the glass or acrylic transparent cover and that faces away from the flexible display panel is a wave surface with wave crest and wave troughs.

8. The mobile terminal according to claim 6, wherein a surface that is of the glass or acrylic transparent cover and that faces the transparent cover is a wave surface or a plane.

## Patentansprüche

1. Mobiles Endgerät, das eine transparente Glas- oder Acrylabdeckung (20) und ein flexibles Anzeigefeld (10) umfasst, wobei das flexible Anzeigefeld (10) ein flexibles Glassubstrat (11) und ein auf dem flexiblen Glassubstrat (11) angeordnetes Anzeigemodul (12) umfasst, und ferner eine Einkapselungsschicht (14) umfasst, die das Anzeigemodul auf dem flexiblen Glassubstrat einkapselt;
wobei eine erste bogenförmige Biegestruktur an jeder von zwei gegenüberliegenden Kanten des flexiblen Glassubstrats angeordnet ist;
wobei eine zweite bogenförmige Biegestruktur (21) auf jeder von zwei gegenüberliegenden Seiten der transparenten Glas- oder Acrylabdeckung angeordnet ist;
wobei eine flache Plattenstruktur (22) der transparenten Glasoder Acrylabdeckung eine konstante Dicke aufweist und wobei die zweite Biegestruktur der transparenten Glas- oder Acrylabdeckung eine Struktur ist, deren Dicke sich allmählich ändert, wobei die Dicke der zweiten Biegestruktur allmählich in einer Richtung der äußeren Erstreckung der zweiten Biegestruktur von der Dicke der flachen Plattenstruktur, wo die zweite Biegestruktur mit der flachen Plattenstruktur zusammengefügt ist, bis zu einer maximalen Dicke an einer Mittellinie der zweiten Biegestruktur zunimmt und die Dicke der zweiten Biegestruktur dann allmählich in der Richtung der äußeren Erstreckung der zweiten Biegestruktur von der Dicke an der Mittellinie zu einer Dicke an der äußeren Erstreckung abnimmt;
wobei eine Flexibilität des flexiblen Glassubstrats es ermöglicht, dass das flexible Anzeigefeld so gebogen wird, dass die transparente Glas- oder Acrylabdeckung (20) mit dem flexiblen Anzeigefeld verbunden werden kann;
wobei, wenn die transparente Glas- oder Acrylabdeckung (20) mit dem flexiblen Anzeigefeld verbunden ist, innere konkave Flächen der zweiten bogenförmigen Biegestrukturen (21) sich mit den ersten bogenförmigen Biegestrukturen verbinden und die ersten bogenförmigen Biegestrukturen in einer Eins-zu-Eins-Entsprechung abdecken;
wobei, wenn die transparente Glas- oder Acrylabdeckung (20) mit dem flexiblen Anzeigefeld verbunden ist, die transparente Glasoder Acrylabdeckung (20) mit dem flexiblen Anzeigefeld haftend verbunden ist.

2. Mobiles Endgerät 1 nach Anspruch 1, wobei ein Durchgangsloch (13), das der Lichtübertragung dient, auf dem Anzeigemodul angeordnet ist.

3. Mobiles Endgerät nach Anspruch 2, wobei das Anzeigemodul eine Anode (127), die auf dem flexiblen Glassubstrat angeordnet ist, eine Emissionsschicht, die auf der Anode angeordnet ist, und eine Kathode (121), die auf der Emissionsschicht (124) angeordnet ist, umfasst, wobei die Einkapselungsschicht die Kathode abdeckt, wobei das Anzeigemodul ferner eine Lochinjektionsschicht, eine Lochtransportschicht, eine elektronische Injektionsschicht und eine elektronische Transportschicht umfasst und das Durchgangsloch durch alle Schichten des Anzeigemoduls verläuft.

4. Mobiles Endgerät nach einem der Ansprüche 1 bis 3, wobei die Einkapselungsschicht eine organische Filmschicht oder eine anorganische Filmschicht ist.

5. Mobiles Endgerät nach einem der Ansprüche 1 bis 4, wobei eine Dicke des flexiblen Glassubstrats von 0,02 mm bis 0,3 mm (einschließlich 0,02 mm und 0,3 mm) beträgt.

6. Mobiles Endgerät nach Anspruch 1, wobei die transparente Glasoder Acrylabdeckung unter Verwendung eines optischen Klebstoffs mit dem flexiblen Anzeigefeld haftend verbunden ist.

7. Mobiles Endgerät nach einem der Ansprüche 1 oder 6, wobei eine Oberfläche, die sich auf der transparenten Glas- oder Acrylabdeckung befindet und von dem flexiblen Anzeigefeld abgewandt ist, eine Wellenoberfläche mit Wellenbergen und Wellentälern ist.

8. Mobiles Endgerät nach Anspruch 6, wobei eine Oberfläche der transparenten Glas- oder Acrylabdeckung, die der transparenten Abdeckung zugewandt ist, eine Wellenoberfläche oder eine Ebene ist.

## Revendications

1. Terminal mobile, comprenant un couvercle transparent en verre ou en acrylique (20) et un panneau d'affichage souple (10), le panneau d'affichage souple (10), comprenant un substrat en verre souple (11) et un module d'affichage (12) disposé sur le substrat en verre souple (11), et comprenant en outre une couche d'encapsulation (14) encapsulant le module d'affichage sur le substrat en verre souple ;
dans lequel une première structure de courbure en forme d'arc est disposée sur chacun des deux bords opposés du substrat de verre souple ;
dans lequel une seconde structure de courbure en forme d'arc (21) est disposée sur chacun des deux côtés opposés du couvercle transparent en verre ou en acrylique ;
dans lequel une structure de plaque plate (22) du couvercle transparent en verre ou en acrylique présente une épaisseur constante, et dans lequel la seconde structure de courbure du couvercle transparent en verre ou en acrylique est une structure dont l'épaisseur change progressivement, dans lequel l'épaisseur de la seconde structure de courbure augmente progressivement dans une direction vers l'étendue extérieure de la seconde structure de courbure depuis l'épaisseur de la structure de plaque plate où la seconde structure de courbure est jointe à la structure de plaque plate jusqu'à une épaisseur maximale au niveau d'une ligne centrale de la seconde structure de courbure et l'épaisseur de la seconde structure de courbure diminue ensuite progressivement en épaisseur dans la direction vers l'étendue extérieure de la seconde structure de courbure depuis l'épaisseur au niveau de la ligne centrale jusqu'à une épaisseur au niveau de l'étendue extérieure ; dans lequel une souplesse du substrat en verre souple permet au panneau d'affichage souple d'être plié de telle sorte qu'un couvercle transparent en verre ou en acrylique (20) puisse être relié au panneau d'affichage souple ;
dans lequel, lorsque le couvercle transparent en verre ou en acrylique (20) est relié au panneau d'affichage souple, les surfaces concaves internes des secondes structures de courbure en forme d'arc (21) se relient aux premières structures de courbure en forme d'arc et recouvrent les premières structures de courbure en forme d'arc dans une correspondance biunivoque ;
dans lequel lorsque le couvercle transparent en verre ou en acrylique (20) est relié au panneau d'affichage souple, le couvercle transparent en verre ou en acrylique (20) est relié de manière adhésive au panneau d'affichage souple.

2. Terminal mobile selon la revendication 1, dans lequel un trou traversant (13) utilisé pour la transmission de lumière est disposé sur le module d'affichage.

3. Terminal mobile selon la revendication 2, dans lequel le module d'affichage comprend une anode (127) disposée sur le substrat en verre souple, une couche d'émission disposée sur l'anode, et une cathode (121) disposée sur la couche d'émission (124), la couche d'encapsulation recouvre la cathode, dans lequel le module d'affichage comprend en outre une couche d'injection de trous, une couche de transport de trous, une couche d'injection électronique et une couche de transport électronique et le trou traversant traverse toutes les couches du module d'affichage.

4. Terminal mobile selon l'une quelconque des revendications 1 à 3, dans lequel la couche d'encapsulation est une couche de film organique ou une couche de film inorganique.

5. Terminal mobile selon l'une quelconque des revendications 1 à 4, dans lequel l'épaisseur du substrat en verre souple est de 0,02 mm à 0,3 mm (y compris 0,02 mm et 0,3 mm).

6. Terminal mobile selon la revendication 1, dans lequel le couvercle transparent en verre ou en acrylique est relié de manière adhésive au panneau d'affichage souple à l'aide d'un adhésif optique.

7. Terminal mobile selon l'une quelconque des revendications 1 ou 6, dans lequel une surface qui se trouve sur le couvercle transparent en verre ou en acrylique et qui est orientée à l'opposé du panneau d'affichage souple est une surface d'onde avec une crête d'onde et des creux d'onde.

8. Terminal mobile selon la revendication 6, dans lequel une surface qui est du couvercle transparent en verre ou en acrylique et qui fait face au couvercle transparent est une surface d'onde ou un plan.
